# EUROPEAN PATENT SPECIFICATION

(11) **EP 2 524 616 B1**
(45) Date of publication and mention of the grant of the patent: **10.12.2014**
(21) Application number: 12075017.9
(22) Date of filing: 17.02.2012
(51) Int. Cl.: A44C 17/00

(54) **Gemstone of natural diamond and method applied thereto**
Edelstein aus natürlichem Diamant und darauf angewandtes Verfahren
Pierre précieuse à base de diamant naturel et procédé appliqué à celle-ci

(30) Priority: 16.05.2011 BE 201100293
(43) Date of publication of application: 21.11.2012
(73) Proprietor: DIAMOND TRADING, naamloze vennootschap, 2018 Antwerpen 1 (BE)
(72) Inventor: De Belder, Daniel Boris F., 2910 Essen (BE)
(74) Representative: Donné, Eddy

(56) References cited:
- DE-A1- 4 409 291
- US-A- 5 474 021
- US-A1- 2009 260 396
- US-B1- 6 449 985

## Description

The present invention relates to a gemstone of natural diamond.

Rough diamond gemstones occur in nature in different forms.

If the gemstone is of an irregular shape the rough gemstone is first cleaved, as is known. The aim here is to cleave the rough gemstone according to the natural fracture planes of the gemstone in order to give the rough gemstone a more regular shape.

In some cases the rough gemstone occurs in the pure crystal form of an octahedron.

For the further processing of the rough gemstone it is first examined how the rough gemstone can best be split to preserve the greatest weight.

It is usual to make the rough gemstone artificially more beautiful by optimising the shape of the gemstone for reflection and dispersion.

The above is realised by cutting the gemstone into a certain shape, for example into a brilliant cut diamond, with a large number of facets.

DE 44 09 291 discloses a translucent gemstone, with a front side and a back side, which is cut in a shape whereby the back side has a table substantially coplanar to the front panel.

A disadvantage of this is that when cutting a rough gemstone into such a shape, a lot of material is removed such that the gemstone loses weight and thus value.

Another disadvantage is that complex cutting processes are employed that require a lot of manipulation of the gemstone and tools.

Another disadvantage is that the known cutting processes take up a lot of time. Depending on the size for example, the cutting can take up to a few months.

The purpose of the present invention is to provide a solution to at least one of the aforementioned and/or other disadvantages.

To this end the invention concerns a gemstone of natural diamond, whereby the gemstone has two parallel faces in which the geometric plane that coincides with the aforementioned faces defines the volume of the gemstone and from which a number of facets start, and each facet is parallel to an opposite facet or parallel to a connecting edge of two other facets.

A gemstone according to the invention has a limited number of facets compared to a gemstone that is cut in the known way with a large number of facets.

The foregoing means that the facets of a gemstone according to the invention have larger areas compared to the facets of the known cut gemstones.

An advantage of this is that a gemstone according to the invention reflects more light compared to the known gemstones.

Another advantage of a gemstone according to the invention is that such a gemstone can be realised by removing a minimum of material from the rough gemstone, but nevertheless yields a gemstone that is attractive and has different optical properties compared to the known diamond gemstones.

According to a preferred characteristic of the invention, the shape of at least one of the parallel faces that define the volume of the gemstone is a hexagon.

The foregoing implies that a gemstone according to the invention has a maximum of eight faces or facets.

This results in a gemstone with large facets that reflects incident light very well.

The invention also relates to a method for processing a rough gemstone of natural diamond to obtain a least one gemstone as described above, whereby the rough gemstone is finished by polishing the different faces of the gemstone without any other additional processing.

A method for processing a rough gemstone according to invention has the advantage that such a method requires a minimum number of operations to yield a gemstone.

Another advantage of a method according to the invention is that the yield from the rough gemstone is a maximum.

The invention also relates to a method for processing a rough gemstone of natural diamond to obtain at least one gemstone according to the invention, whereby the rough gemstone is cleaved into the shape of an octahedron and whereby the rough gemstone is further divided by splitting the rough gemstone along a number of planes that are each parallel to a facet of the octahedron.

With the intention of better showing the characteristics of the invention, a few preferred embodiments of a gemstone according to the invention are described hereinafter by way of an example, without any limiting nature, with reference to the accompanying drawings, wherein:
figure 1 schematically shows in perspective a gemstone according to the invention;
figure 2 shows a variant of figure 1;
figure 3 shows the natural crystal form of diamond;
figure 4 schematically shows in perspective a longitudinal cross-section of figure 3;
figure 5 shows a gemstone according to figure 3 that is cut along three planes;
figure 6 shows a gemstone according to figure 3 that is cut along eight planes.

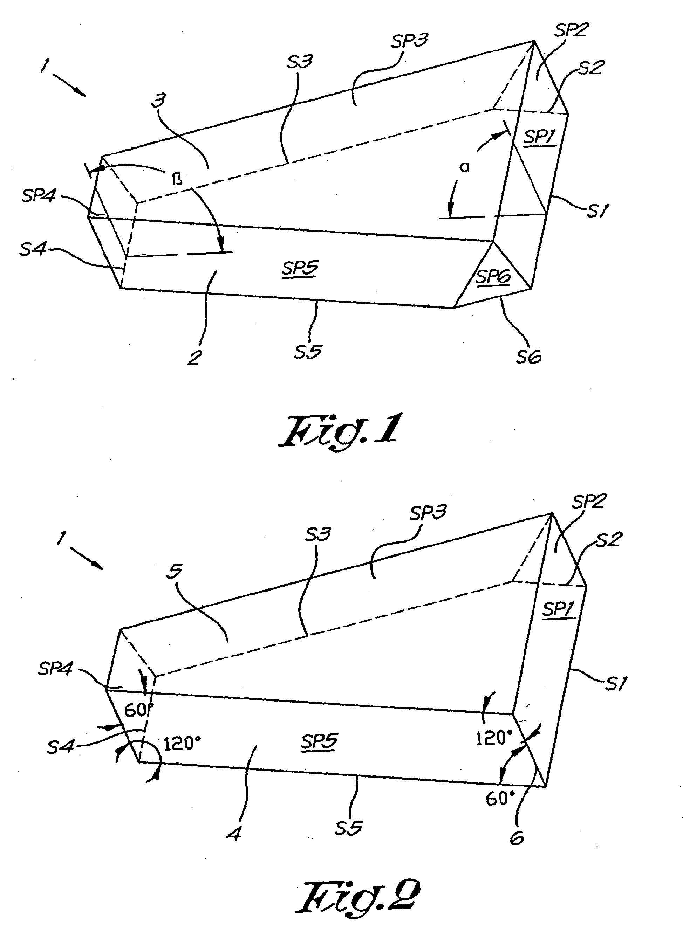

Figure 1 shows a gemstone 1 of natural diamond with two parallel faces 2, 3 whose geometric plane that coincides with the aforementioned faces defines the volume of the gemstone 1.

In this case the form of one of the aforementioned parallel faces 2 is in the shape of a hexagon while the other face 3 is in the shape of a quadrangle.

As shown in figure 1 the hexagon has six sides S1, S2, S3, S4, S5 and S6. The sides of the hexagon S1 and S4, S2 and S5, S3 and S6 are parallel to one another in pairs.

A number of facets start from the sides S1 to S6 inclusive of the hexagon, respectively facets, SP1, SP2, SP3, SP4, SP5 and SP6.

In a gemstone 1 according to the invention, the opposite facets SP1 and SP4, SP2 and SP5, and SP3 and SP6 are parallel to one another in pairs. In other words facet SP1 is parallel to facet SP4, facet SP2 is parallel to facet SP5 and so on.

Each facet of the gemstone 1 makes an included angle with the face 2 of the hexagon. Included angle means the angle that is embedded in the body of the gemstone 1.

As shown in figure 1, the facet SP1 makes an angle α with the face 2 of the hexagon, while the facet SP4 makes an angle β with the face 2 of the hexagon.

As the facets SP1 and SP4 are parallel to one another, the angles α and β together form an angle of 180 degrees. The angles α and β are consequently supplementary angles.

In a preferred embodiment of a gemstone 1 according to the invention, the included angles of each pair of parallel facets SP1-SP4, SP2-SP5, SP3-SP6 to the face of the hexagon are respectively 60 and 120 degrees.

It is clear that in this case the gemstone 1 according to the invention has a total of eight faces or facets and that such a gemstone 1 appears in the form of a rhomboid.

Figure 2 shows a variant embodiment of a gemstone 1 according to the invention that also consists of two parallel faces 4, 5 that define the volume of the gemstone 1.

The gemstone 1 shown in figure 2 contains 4 facets that are parallel to one another in pairs. Thus the facet SP1 is parallel to facet SP4 and facet SP2 is parallel to facet SP5.

The gemstone 1 according to figure 2 is further **characterised in that** the connecting edge 6 of the two facets SP1 and SP5 is parallel to facet SP3 of the gemstone 1.

The embodiment of a gemstone 1 according to figure 2 is preferable as each facet SP1, SP2, SP3, SP4 and SP5 includes an angle of 60 and 120 degrees to the parallel faces 4, 5.

Furthermore, one or more edges of the gemstone 1 can be provided with bezels, not shown in the drawing, without departing from the scope of the invention.

The invention also relates to a method for processing a rough gemstone of natural diamond. More specifically, the purpose of the method according to the invention is to extract at least one gemstone from the rough gemstone that has the characteristics of the gemstone 1 according to the invention.

In a method according to the invention, the rough gemstone is finished by cutting or polishing the limited number of faces or facets of the gemstone without any other additional processing.

In those cases where the shape of the rough gemstone is irregular, a method according to the invention enables the rough gemstone to first be cleaved into the form of an octahedron 7.

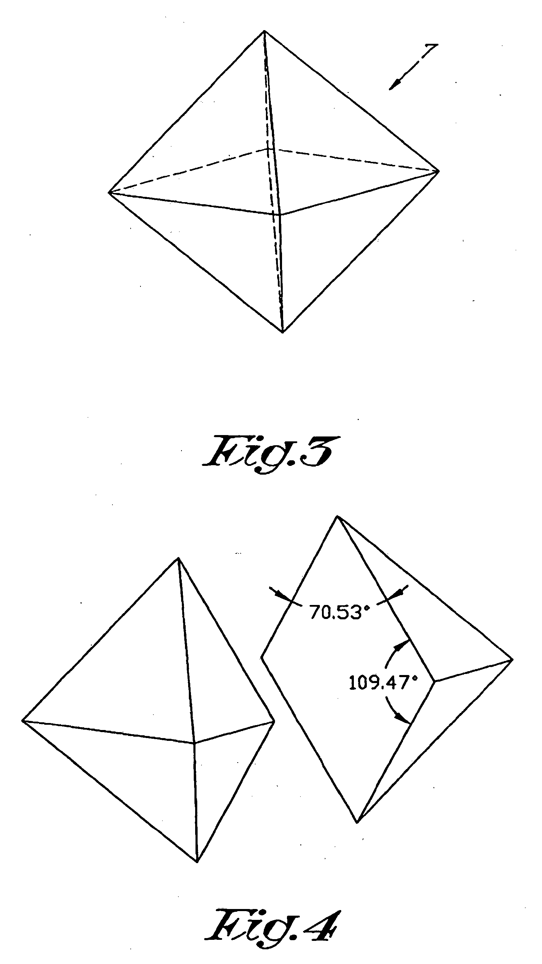

Figure 3 shows the pure crystal form of an octahedron 7 whereby each facet takes on the shape of an equilateral triangle. The angles that are characteristic of such an octahedron 7 are shown in figure 4.

The aforementioned angles are obtained by cutting the octahedron 7 along the longitudinal plane. The obtuse angle, also called the dihedral angle, is 109.47 degrees. The acute angle above the section is 70.53 degrees.

Diamond occurs in nature in a form that differs from the pure crystal form of an octahedron 7. Hereby the shape of the facets differ from the shape of an equilateral triangle, but the angles that are characteristic of an octahedron are preserved.

The method according to the invention further consists of the rough gemstone, in the form of an octahedron 7, being further divided by splitting the rough gemstone along a number of planes.

Each of the aforementioned planes is characterised by each plane being parallel to a facet of the octahedron 7.

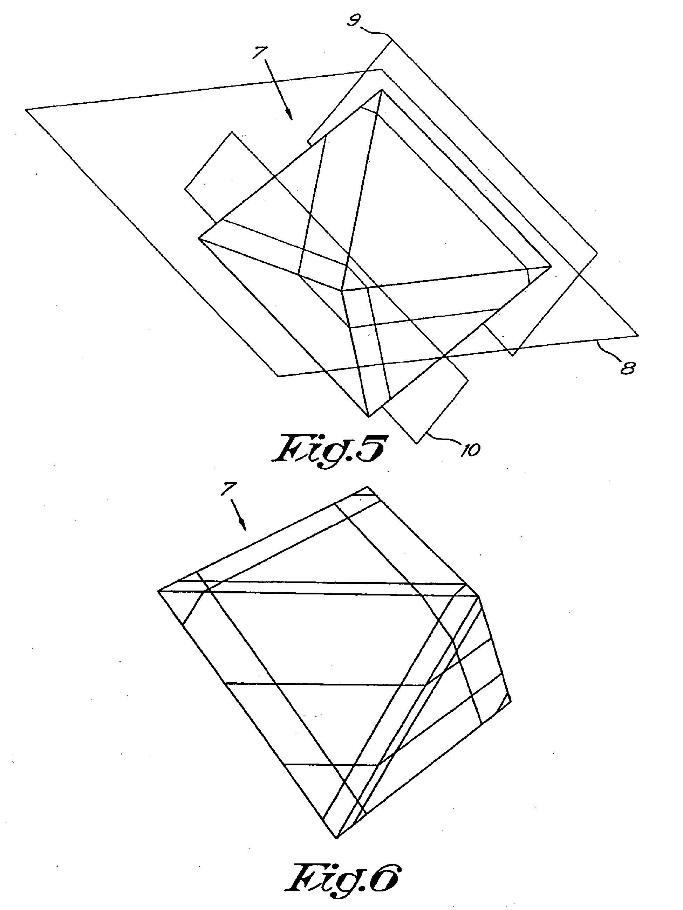

Figure 5 shows a rough gemstone in the pure crystal form of an octahedron 7. The drawing further shows three different planes 8, 9 and 10 that are each parallel to a face of the octahedron 7.

In this case by cutting the rough gemstone according to three planes 8, 9 and 10 at least one gemstone is obtained that has the characteristics of a gemstone 1 according to the invention.

A method according to the invention also enables the rough gemstone to be split in the shape of an octahedron 7 along an arbitrary number of planes, but with the characteristic that each plane is parallel to a facet of the octahedron 7. Figure 6 shows the result of a rough gemstone in the form of an octahedron 7 that is split according to eight planes whereby each plane is parallel to a facet of the octahedron 7.

In practice, the gemstone can be split along a certain plane 8, 9 or 10 in different ways.

Indeed, the splitting can be done by cutting, cleaving and/or grinding the gemstone.

The method for processing a rough gemstone of natural diamond preferably starts with a gemstone in the pure crystal form of an octahedron, as shown in figures 3, 5 and 6. Such a method can also be applied to a rough gemstone that differs from the pure crystal form, without departing from the scope of the invention.

The aforementioned method does not exclude the cutting of bezels on the edges of at least one gemstone 1 according to the invention. The application of bezels results in extra facets, but does not affect the shape of the gemstone, as the aforementioned extra facets are significantly smaller in area compared to the other faces of a gemstone according to the invention.

The present invention is by no means limited to the embodiments described as an example and shown in the drawings, but a gemstone according to the invention with accompanying method can be realised in all kinds of variants, without departing from the scope of the invention as defined by the claims.

## Claims

1. Gemstone of natural diamond, **characterised in that** the gemstone (1) has two parallel faces (2-3, 4-5) in which the area enclosed by the composite perimeter of the projection of the planes upon each other defines the volume of the gemstone (1), and from which a number of facets start, and each facet is parallel to an opposite facet or parallel to a connecting edge (6) of two other facets, and whereby the gemstone (1) has a maximum of eight faces.

2. Gemstone according to claim 1, **characterised in that** the shape of at least one of the aforementioned parallel faces (2, 3) is a hexagon.

3. Gemstone according to claim 2, **characterised in that** the sides (S1, S2, S3, S4, S5, S6) of the hexagon are parallel to one another in pairs.

4. Gemstone according to claim 3, **characterised in that** the facets (SP1, SP2, SP3, SP4, SP5, SP6) start from the sides (S1, S2, S3, S4, S5, S6) of the hexagon, whereby the facets are parallel to one another in pairs.

5. Gemstone according to claim 4, **characterised in that** each pair of parallel facets (SP1-SP4) includes an angle (α-β) to the face of the hexagon of 60 and 120 degrees respectively.

6. Method for processing a rough gemstone of natural diamond in order to obtain at least one gemstone according to any of the claims 1 to 5, **characterised in that** the rough gemstone is cleaved into the shape of an octahedron (7) and that the rough gemstone is further divided by splitting the rough gemstone along a number of planes that are each parallel to a facet of the octahedron (7).

7. Method according to claim 6, **characterised in that** the rough gemstone is divided by splitting the gemstone (1) along three planes (8, 9, 10).

8. Method according to claim 6, **characterised in that** the rough gemstone is divided by splitting the gemstone (1) along eight planes.

## Patentansprüche

1. Edelstein aus natürlichem Diamant, **dadurch gekennzeichnet, dass** der Edelstein (1) zwei parallele Flächen (2-3, 4-5) aufweist, wobei das vom zusammengesetzten Umfang der Projektion der Ebenen aufeinander eingeschlossene Gebiet das Volumen des Edelsteins (1) definiert, und von denen eine Anzahl von Facetten ausgehen, und jede Facette parallel zu einer gegenüberliegenden Facette oder parallel zu einer Verbindungskante (6) zweier anderer Facetten ist, und wobei der Edelstein (1) ein Maximum von acht Flächen aufweist.

2. Edelstein nach Anspruch 1, **dadurch gekennzeichnet, dass** die Form von mindestens einer der vorgenannten parallelen Flächen (2, 3) ein Sechseck ist.

3. Edelstein nach Anspruch 2, **dadurch gekennzeichnet, dass** die Seiten (S1, S2, S3, S4, S5, S6) des Sechsecks paarweise parallel zueinander sind.

4. Edelstein nach Anspruch 3, **dadurch gekennzeichnet, dass** die Facetten (SP1, SP2, SP3, SP4, SP5, SP6) von den Seiten (S1, S2, S3, S4, S5, S6) des Sechsecks ausgehen, wobei die Facetten paarweise parallel zueinander sind.

5. Edelstein nach Anspruch 4, **dadurch gekennzeichnet, dass** jedes Paar paralleler Facetten (SP1-SP4) einen Winkel (α-β) zu der Seite des Sechsecks von 60 beziehungsweise 120 Grad einschließt.

6. Verfahren zur Bearbeitung eines Rohedelsteins aus natürlichem Diamant, um mindestens einen Edelstein nach einem der Ansprüche 1 bis 5 zu erhalten, **dadurch gekennzeichnet, dass** der Rohedeistein in die Form eines Oktaeders (7) gespalten wird und dass der Rohedelstein durch Spalten des Rohedeisteins entlang einer Anzahl von Ebenen, die jede parallel zu einer Facette des Oktaeders (7) sind, weiter aufgeteilt wird.

7. Verfahren nach Anspruch 6, **dadurch gekennzeichnet, dass** der Rohedelstein durch Spalten des Edelsteins (1) gemäß drei Ebenen (8, 9, 10) aufgeteilt wird.

8. Verfahren nach Anspruch 6, **dadurch gekennzeichnet, dass** der Rohedelstein durch Spalten des Edelsteins (1) gemäß acht Ebenen aufgeteilt wird.

## Revendications

1. Gemme de diamant naturel, **caractérisée en ce que** la gemme (1) possède deux faces parallèles (2-3, 4-5) dans lesquelles la surface délimitée par le périmètre composite de la projection des plans l'un sur l'autre définit le volume de la gemme (1) et à partir desquelles s'étendent un certain nombre de facettes, et chaque facette est parallèle à une facette opposée ou parallèle à un bord de liaison (6) de deux autres facettes, et la gemme (1) possède un maximum de huit faces.

2. Gemme selon la revendication 1, **caractérisée en ce que** la configuration d'au moins une des faces parallèles susmentionnées (2-3) est un hexagone.

3. Gemme selon la revendication 2, **caractérisée en ce que** les côtés (S1, S2, S3, S4, S5, S6) de l'hexagone sont parallèles l'un à l'autre par paires.

4. Gemme selon la revendication 3, **caractérisée en ce que** les facettes (SP1, SP2, SP3, SP4, SP5, SP6) s'étendent à partir des côtés (S1, S2, S3, S4, S5, S6) de l'hexagone, les facettes étant parallèles les unes aux autres par paires.

5. Gemme selon la revendication 4, **caractérisée en ce que** chaque paire de facettes parallèles (SP1-SP4) forme un angle (α-β) par rapport à la face de l'hexagone de 60 et 120 ° respectivement.

6. Procédé pour traiter une gemme brute de diamant naturel pour obtenir au moins une gemme selon l'une quelconque des revendications 1 à 5, **caractérisé en ce qu'**on soumet la gemme brute à un clivage pour obtenir la configuration d'un octaèdre (7) et **en ce qu'**on soumet la gemme brute à une division ultérieure par séparation de la gemme brute le long de plusieurs plans qui sont chacun parallèles à une facette de l'octaèdre (7).

7. Procédé selon la revendication 6, **caractérisé en ce qu'**on divise la gemme brute par séparation de la gemme (1) le long de trois plans (8, 9, 10).

8. Procédé selon la revendication 6, **caractérisé en ce qu'**on divise la gemme brute par séparation de la gemme (1) le long de huit plans.
